# EUROPEAN PATENT APPLICATION

(11) **EP 2 299 473 A1**
(43) Date of publication of application: **23.03.2011**
(21) Application number: 09170999.8
(22) Date of filing: 22.09.2009
(51) Int. Cl.: H01L 21/00, B65H 23/26, B65H 23/06

(54) **Modular substrate processing system and method**

(71) Applicant: Applied Materials, Inc., Santa Clara, CA 95054 (US)
(72) Inventor: Herzog, Andre, 63755 Alzenau (DE); Morrison, Neil, 63654 Buedingen (DE); Hein, Stefan, 63825 Blankenbach (DE); Sauer, Peter, 36381 Schluechtern (DE)
(74) Representative: Zimmermann & Partner

(57) **Abstract**

A modular substrate processing system is provided for processing a flexible substrate. The system includes at least two process modules arranged adjacent to each other in a horizontal direction. The process modules include gas cushion rollers adapted for contactless guiding of the flexible substrate and for diverting the flexible substrate in vertical directions.

## Description

### TECHNICAL FIELD OF THE INVENTION

Embodiments of the present invention relate to a substrate processing system, and in particular relate to a substrate processing system having a modular structure. Furthermore, embodiments of the present invention relate to a method of processing a flexible substrate.

### BACKGROUND OF THE INVENTION

The manufacture of large area photovoltaic devices on flexible substrates is of increasing importance. Solar cells formed on flexible substrates have abundant applications in electronic devices and energy conversion units. The production of large area thin film photovoltaic devices is based on surface deposition, etching, activation, passivation and other surface-related processes. In this context, deposition processes such as plasma-assisted thin film deposition processes provide a powerful tool for the generation of a large variety of thin film devices.

For example, using PECVD processes thin film silicon solar cells or thin film transistors are deposited onto a flexible substrate. Processing of flexible substrates may be performed in a processing line including a number of processing stations or modules. Individual thin films or layer stacks are applied onto a substrate surface wherein the films or layers may have a variable composition. A deposition of the individual layers of a layer stack onto the flexible substrate is a challenging issue with respect to a layout of a substrate processing system.

It is a desire to provide a cost-effective processing of flexible substrates using a processing system having low maintenance costs and a large flexibility. The control and adjustment of film thicknesses and film compositions are further issues.

### SUMMARY OF THE INVENTION

In light of the above, a modular substrate processing system adapted for processing a flexible substrate according to independent claim 1 and a method for processing a flexible substrate according to independent claim 13 are provided.

According to one embodiment, a modular substrate processing system adapted for processing a flexible substrate is provided. The system includes at least two process modules arranged adjacent to each other in a horizontal direction, wherein the process modules include gas cushion rollers adapted for contactless guiding the flexible substrate and for diverting the flexible substrate in vertical directions.

According to a further embodiment, a method for processing a flexible substrate is provided. The method includes moving the flexible substrate into a first process module, via an insertion unit, in a horizontal direction; processing the flexible substrate in the first process module; moving the flexible substrate out of the first process module; moving the flexible substrate into at least one second process module; processing the flexible substrate in the second process module; and moving the flexible substrate out of the second process module, via an ejection unit, in a horizontal direction, wherein the flexible substrate is diverted in vertical directions within each process module by means of at least one gas cushion roller.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
- Figure 1: is a schematic side view of a modular substrate processing system in accordance with a first embodiment;
- Figure 2: depicts a process module of the modular substrate processing system shown in FIG. 1 in more detail;
- Figures 3A and 3B: are schematic views of gas cushion rollers, according to a typical embodiment;
- Figure 4: is a schematic side view of a modular substrate processing system in accordance with a further embodiment;
- Figure 5: is a side sectional view of a process module in accordance with yet a further embodiment;
- Figure 6: is a schematic side sectional view of a modular substrate processing system in accordance with yet another embodiment; and
- Figure 7: is a flowchart illustrating a method for processing a flexible substrate.

### DETAILED DESCRIPTION OF THE EMBODIMENTS

Reference will now be made in detail to the various embodiments of the invention, one or more examples of which are illustrated in the figures. Within the following description of the drawings, the same reference numbers refer to the same components. Generally, only the differences with respect to individual embodiments are described. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

Embodiments described herein refer inter alia to a substrate processing system adapted for processing a flexible substrate such as a web for flexible photovoltaic devices. In particular, the substrate processing system is adapted for a continuous processing of a flexible substrate such as a web unwound from an unwinding module. The processing system is configured in a modular design, i.e. an appropriate number of process modules may be arranged adjacent to each other in a processing line, and the flexible substrate is inserted into the first process module and may be ejected from the last process module of the line. Furthermore, the entire system may easily be reconfigured if a change of individual processing operations is desired. The deposition of thick films in a single deposition chamber, however, may result in a contamination of the chamber with dust, particles and/or precursor material.

It is noted here that a flexible substrate or web as used within the embodiments described herein can typically be **characterized in that** it is bendable. The term "web" may be synonymously used to the term "strip" or the term "flexible substrate". For example, the web as described in embodiments herein may be a foil.

The web of substrate material may be continuously advanced through the line of interconnected process modules. In each process module a specific layer of a photovoltaic device may be deposited. For example, if the photovoltaic device includes a n-i-p configuration of layers, a first process module may be adapted for depositing a n-type layer therein, one or more succeeding process modules may be adapted for depositing an intrinsic or i-type layer therein, and a last process module may be adapted for depositing a p-type layer therein. Thus it is possible to provide different film thicknesses of a specific film by providing an appropriate number of process modules where the specific film is deposited.

Film thicknesses and film compositions may be appropriately controlled by applying individual processes in dedicated process modules. For example, a deposition of an absorber in flexible, silicon-based photovoltaic devices is based on the deposition of thin doped layers of silicon, e.g. using boron, phosphorus, separated by an intrinsic layer of silicon.

Typically, the doped layers, e.g. n-type layers or p-type layers, have thicknesses in a range from 10 nm to 40 nm, whereas the intrinsic layer has a thickness in a range from 200 nm to 2000 nm. These differences in film thickness and composition have an influence on the layout of the substrate processing system and on the number of process modules provided for a deposition of a specific layer or film. Throughput and productivity of the substrate processing system are based on the number of plasma sources used for the individual layer types. Furthermore, as a consequence of low deposition rates provided by PECVD processes, process drift associated with the formation of dust and/or particles has to be avoided.

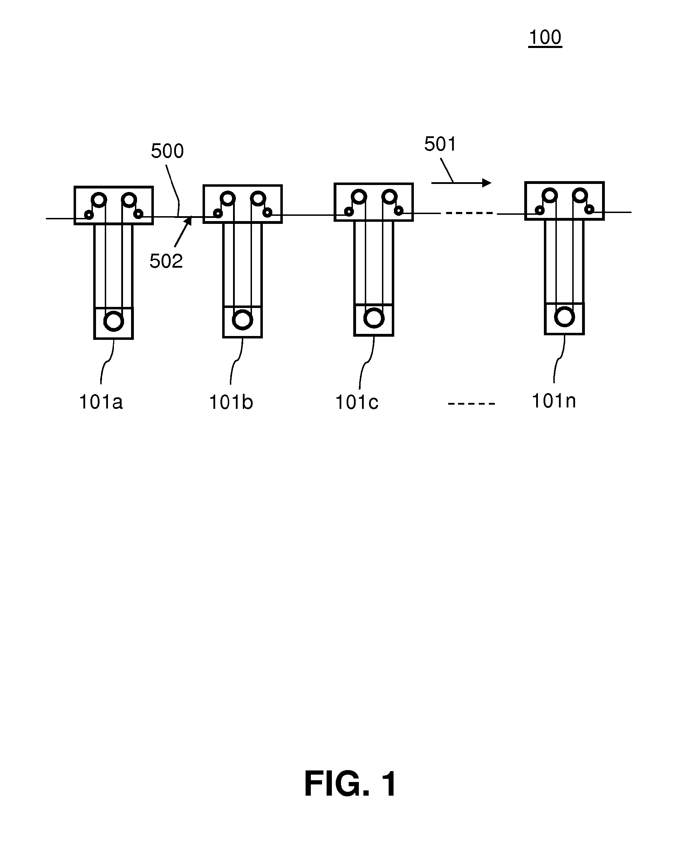

FIG. 1 is a schematic side view of a modular substrate processing system 100 in accordance with a first embodiment. The modular substrate processing system 100 includes a number of process modules 101a, 101b, 101c, ... 101n. A flexible substrate 500 is shown to be inserted into a first process module 101a, and to be ejected, after appropriate processing operations or processing steps, from a last process module 101n. Thus each process module 101a-101n has upstream components on the side where the substrate is inserted in the process module, and downstream components on the side where the substrate is ejected from that process module, such as an upstream gas cushion roller and a downstream gas cushion roller which will be described herein below.

Furthermore, the transport speed of the flexible substrate through the substrate processing system - and through the individual process modules - is based on the number of process modules. A transport speed which is used to move the flexible substrate through the process modules 101a-101n is in a range from 0.1 m/min to 1.0 m/min, and typically amounts to 0.7 m/min.

The flexible substrate 500 may be provided as a web which is wound up on a roll and has a width in a range from 80 cm to 120 cm, and typically has a width of approximately 100 cm. According to yet further embodiments, which can be combined with other embodiments described herein, two or more webs can be processed in parallel such that the webs are inserted into the processing system 100 in parallel. If two webs are processed in parallel, these parallel strips of webs each may have a width in a range from 40 cm to 60 cm, and typically have a width of approximately 50 cm. The flexible substrate 500 may have a thickness in a range from 15 µm to 500 µm, and typically has a thickness of approximately 50 µm.

It is noted here that, in order to avoid damage to a substrate surface 502 to be processed (front surface, front face), the gas cushion rollers are arranged such that they face the front surface 502. The front surface, or front face, of the substrate 500 is to be understood as the surface which may be processed, e.g. on which layers are deposited. The gas cushion rollers provided in each process module may be formed as hydrodynamic gas bearings providing a contact-free or nearly contact-free transport of the flexible substrate. In particular, the sensitive front surface 502 of the flexible substrate 500 is not contacted by transport rollers.

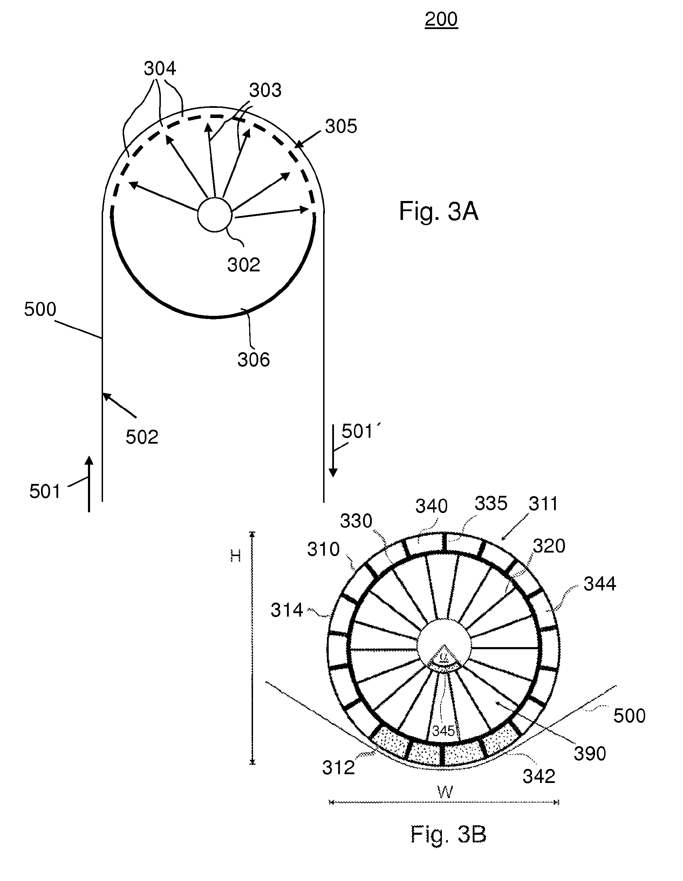

Based on the fact that gas cushion rollers are provided for guiding the flexible substrate 500, there is no harmful mechanical contact of the front surface 502 of the flexible substrate 500 with respect to the gas cushion rollers. A layout of a gas cushion roller used within a process module 101 will be described herein below with respect to FIG. 3.

A lateral dimension of the modular substrate processing system 100, i.e. a dimension extending in the substrate transport direction 501 may be reduced by arranging processing chambers of individual process modules in a vertical orientation. Furthermore, according to embodiments described herein, a horizontal movement of the substrate from one module to the next module and, thereby, a horizontal web control can be realized. In addition to that a vertical movement of the flexible substrate can be provided during deposition of a thin-film on the substrate by the arrangement of the modular system. Thereby, parasitic particles from the deposition process that might be generated in the deposition regions are less likely to fall on the front face of the substrate, such that, for example damages to the deposited layers may occur due to flaking down of particles.

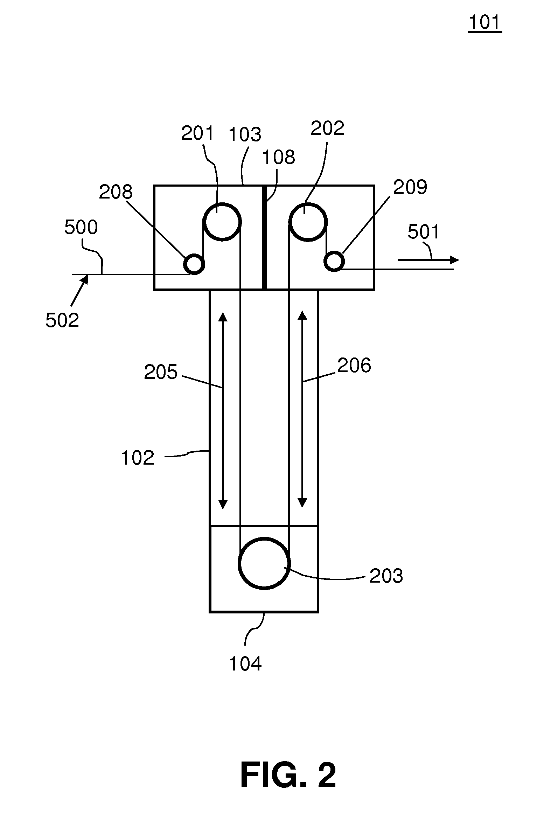

FIG. 2 depicts a process module 101 of the modular substrate processing system 100 shown in FIG. 1, in more detail. In particular, a substrate guiding means 103, 104 adapted for guiding the flexible substrate 500 through at least one processing region of the process module 101 is described herein below. Further, a substrate processing chamber may include at least two processing regions which are formed within the processing chamber wherein the processing regions are adapted for processing the substrate front surface 502.

The guiding means of the process module 101 includes a first substrate guiding device 103 into which the flexible substrate 500 is inserted in a horizontal direction and a second substrate guiding device 104 where the flexible substrate is diverted from a vertically downward moving direction to a vertically upward moving direction. According to embodiments, which can be combined with other embodiments described herein, the first substrate guiding device 103 includes two gas cushion rollers 201, 202. Furthermore, a processing chamber 102 is arranged between the first and second substrate guiding devices 103, 104.

A substrate surface 502 to be processed, i.e. a front surface of the substrate 500 is shown to be a lower surface when transporting the substrate 500 in the horizontal direction. In FIG. 2 the substrate 500 is shown to be transported from a left side to a right side in the figure in a substrate transport direction 501.

In order to reduce lateral dimensions of a modular substrate processing system 100 shown in FIG. 1 the substrate processing chamber 102 extends in a vertical direction. At least two processing regions are formed within the processing chamber 102, i.e. a first processing region 205 and a second processing region 206, which are adapted for processing the substrate front surface 502. Thus the orientation of the flexible substrate 500 is vertical during a processing operation and horizontal during transport from one process module to an adjacent process module.

Depending on the kind of surface treatment appropriate processing devices such as plasma sources may be arranged in at least one of the processing regions 205, 206. Surface treatment such as surface coating, surface activation/passivation and other surface-related processes are carried out in one or more of the process modules 101 of the modular substrate processing system 100. Plasma-assisted surface processes provide a powerful tool for activating and/or coating and/or etching a variety of substrates. During these plasma processes the flexible substrate 500 is moved through respective process modules 101. Thus, different process modules 101a-101n and/or different processing regions 205, 206 can be used to perform different processing steps in a substrate processing operation. E.g. one specific process module 101a-101n may be provided for one kind of film composition, whereas another process module is only used for substrate cleaning, substrate heating, substrate activation, etc.

According to yet further embodiments, which can be combined with any of the other embodiments and modifications described herein, individual process modules may be provided for a deposition of specific layers. For example, in a deposition process which can be used for manufacturing layer stacks of flexible photovoltaic devices, a first process module 101a may be provided for depositing a n-Si-layer, 12 subsequent process modules may be provided for depositing an i-Si-layer, and a last process module 101n may be provided for depositing a p-Si-layer. Thus an n-i-p layer stack is formed which includes a thin p-Si-layer, a thin n-Si-layer, and a thick i-Si-layer embedded between the p-Si-layer and the n-Si-layer.

According to an optional modification thereof, at least one first process module 101a may be provided for depositing an n-Si-layer, 2 to 32 subsequent process modules may be provided for depositing an i-Si-layer, and a last one process module 101n may be provided for depositing a p-Si-layer. Again a n-i-p layer stack is formed which includes a thin p-Si-layer, a thin n-Si-layer, and a thick i-Si-layer embedded between the p-Si-layer and the n-Si-layer.

In the same manner, instead of using an entire process module for a specific processing operation, in a process module which is divided into processing regions different processing operations may be performed. As an example, processing a flexible substrate may include depositing a first layer onto the flexible substrate 500 in a first processing region 205 of the first process module 101a and depositing at least one second layer onto the flexible substrate 500 in a second processing region 206 of the first process module and in at least one second process module 101b-101n.

Accordingly, according to some embodiments, which can be combined with other embodiments described herein, the processing regions 205, 206 in one or more of the process modules can be configured to conducted different substrate processing steps. Accordingly, one module can be used for different substrate processing steps, which further increases the flexibility of the system.

For guiding a horizontally inserted flexible substrate 500 and for diverting the flexible substrate 500 in vertical directions the first and second substrate guiding devices 103, 104 are provided which are described in the following. After inserting the flexible substrate 500 into the first substrate guiding means 103, according to some embodiments, an input guiding roller 208 contacting the substrate 500 at its back side opposing the front surface 502 can guide the substrate 500 to an upstream gas cushion roller 201 which provides a gas cushion between the front surface 502 and a roller surface and which diverts the flexible substrate downwards in a vertical direction. Thus a gas cushion roller-based continuous substrate transport is provided.

The gas cushion provided by the upstream gas cushion roller 201 prevents damages to the sensitive front surface 502 of the substrate 500 such as scratches, dust deposition, contamination, etc. The flexible substrate 500 then moves downward with its front surface 502 passing the first processing region 205. Here, surface treatment such as surface coating, surface activation/passivation and other surface-related processes may be carried out. Then the flexible substrate 500 is inserted into the substrate guiding device 104 where the flexible substrate 500 is diverted from a vertical downward movement to a vertical upward movement by means of an intermediate roller 203.

As this intermediate roller 203 is facing the back surface of the substrate 500, the intermediate roller 203 may directly contact this back surface and need not be designed as a gas cushion roller like the rollers 201 and 202. It is noted here, albeit not shown in the drawings, that rollers contacting a back surface of the flexible substrate 500 such as the rollers 208, 209 and 203 described herein above may be used as driving rollers for driving the substrate 500 in the substrate transport direction 501 at a transport speed.

After being diverted by the intermediate roller 203 the substrate 500 moves through the second processing region 206, again enters the first substrate guiding device 103 and passes over a downstream gas cushion roller 202 contacting the front surface 502 of the substrate 500, and over an output guiding roller 209 where the substrate 500 is ejected from the process module 101. Furthermore, a separation wall 108 is formed between an upstream side of the first substrate guiding means 103, where the rollers 201, 208 are arranged, and a downstream side of the first substrate guiding means 103, where the rollers 202, 209 are arranged. The separation wall 108 may provide a gas separation between the first processing region 205 and the second processing region 206 and/or a gas separation between an upstream portion and a downstream portion of the first guiding device 103.

FIG. 3A is a schematic view of a gas cushion roller 200 such as the upstream gas cushion roller 201 or the downstream gas cushion roller 202 of an individual process module 101. In process module applications for processing a flexible substrate 500 such as in the production of thin-film solar cells the flexible substrate 500 may be diverted in moving directions. Thus a roller 306 may be provided for changing the moving direction 501 of the flexible substrate 500.

Examples of a gas cushions, which can be used with embodiments described herein, are described in U.S. patent application Ser. No. 12/255,389, entitled "Hover cushion transport for webs in a web coating process" filed October 21, 2008, which is incorporated herein by reference to the extent that the applications are not inconsistent with this disclosure. Therein, for example, a guiding device for contact-free guiding a flexible substrate is provided with the device having a surface for facing the substrate and a multitude of gas outlets disposed in the surface and adapted for providing a hover cushion for the substrate.

As shown in FIG. 3A, according to a typical embodiment the transport direction 501 of the moving substrate 500 may be changed from a vertically upward movement 501 to a vertically downward movement 501'. A direct contact of the front surface 502 to be processed with the roller 306 may be avoided by providing a gas cushion 305 between the roller 306 and the front surface 502 of the substrate 500.

A gas cushion adapted for avoiding the direct contact of the front surface 502 of the substrate 500 with the roller 306 is provided by gas 303 which is inserted in a space between the flexible substrate 500 and the roller 306. The gas 303 is emitted from gas outlets 304 in the surface of the roller 306, and the substrate 500 with its front surface 502 facing the gas outlets 304 of the roller 306 does not contact the roller 306 directly but hovers on the cushion 305 of the emitted gas 303.

The surface of the roller 306 at which the gas outlets 304 for emitting the gas 303 are arranged may be cylindrical in shape. Furthermore, according to other embodiments which may be combined with at least one embodiment described herein, a cross section of the roller 306 may be non-circular, convex, a segment of a circle, a facetted protrusion, and may exhibit other appropriate forms for a contact-free guiding of the flexible substrate 500.

According to a typical embodiment which may be combined with other embodiments described herein, the upstream gas cushion roller 201 and/or the downstream gas cushion roller 202 of an individual process module 101 shown in FIG. 2 are employed for diverting the flexible substrate 500 by an angle of typically 180 degrees such that the surface of the roller 306 at which the gas outlets 304 for emitting the gas 303 are arranged is provided as approximately a half circle. The roller 306 itself may be rotatable about a rotation axis, or the roller 306 may be fixed in its position while the flexible substrate 500 is moving over the gas cushion 305.

According to some embodiments, which can be combined with other embodiments described herein, process gas for processing the substrate surface 502 may be provided by the gas cushion roller 200 via the gas outlets 304. Thus, both gas supply and substrate guiding may be performed by the gas cushion roller 200 shown in FIG. 3A.

According to yet further embodiments of a gas cushion roller, which can be combined with other embodiments described herein, are described in U.S. patent application Ser. No. 12/427,453, entitled "Guiding devices and methods for contactless guiding of a web in a web coating process" filed April 21, 2009, which is incorporated herein by reference to the extent that the applications are not inconsistent with this disclosure. According to embodiments described therein, a guiding device for contactless guiding of a web in a web coating process application under vacuum conditions is provided. The guiding device includes a curved surface for facing the web and a group of gas outlets disposed in the curved surface and adapted for giving off a gas flow to form a hover cushion between the curved surface and the web. The guiding device further includes a gas distribution system for selectively providing the gas flow to a first subgroup of the gas outlets and for preventing the gas from flowing to a second subgroup of the gas outlets.

For example, according to embodiments, which can be combined with other embodiments described herein, Fig. 3B shows a guiding device including a rotationally symmetric surface 310. The guiding device is shown in a cross-sectional view and has a width W and a height H. A depth D of the guiding device is oriented perpendicularly to the plane of drawing. Typically, the web guiding device is a cylindrical drum with constant width W and height H. Alternatively, the width W and height H may vary along the depth D, e.g. linearly such that the guiding device is a cone or truncated cone. The cone or truncated cone may, e.g., be used if a lateral off-set in guiding the web is desired, i.e., if the web should be displaced in the direction of the depth D.

In Fig. 3B, a first subgroup 312 of the gas outlets, i.e., the open gas outlets 312, lie in the web guiding region. The first subgroup 312 of the gas outlets 311 is overlapped by the substrate web 500. Herein, the term "overlapped" does not imply a contact of the substrate web 500 and the surface 310 because, during operation, the hover cushion is formed between the first subgroup 312 of the gas outlets in the web guiding region and the web 500. Thereby, generally, a direct contact between the web and the guiding device is avoided.

The second subgroup 314 of the gas outlets, i.e., the closed gas outlets 314, lies outside of the web guiding region. Since gas is only emitted in the web guiding region where it is needed to form the hover cushion, meaning no or little gas is directly emitted into a region not overlapped by the web, waste of gas may be reduced and/or a better vacuum be maintained at lesser strain on the pump system. In particular, if the gas outlets not overlapped by the web were open, an even higher pressure of the gas would be needed to create a hover cushion, thus adding to the waste of gas and/or load on the pump system.

According to some embodiments, as shown in Fig. 3B, the gas distribution system 390 is a star distributor. Generally, the gas distribution system 390 includes a main gas feed 345 and individual gas outlet feeds 320 in fluid communication with the gas outlets 311. In some embodiments illustrated in Fig 3B, the gas distribution system 390 may further include sector chambers 340. Sector chambers, which will be described in more detail below, may serve to simplify the construction of the gas distribution system, since the gas needs only be provided to each sector chamber, and not necessarily to each individual gas outlet.

As shown in Fig. 3B, the sector chambers 340 can be formed by a rotationally symmetric inner wall 330, a plurality of radial sector walls 335 and the surface 310. The gas outlet feeds 320 are in fluid communication with the sector chambers 340 through gas inlets. The gas outlet feeds 320 are adapted to provide the gas to the sector chambers 340 via gas inlets if the gas outlet feeds 320 are in fluid communication with the main gas feed 345.

Fig 3B shows sector chambers 342 in fluid communication with the main gas feed 345 and sector chambers 344 not in fluid communication with the main gas feed 345. Therefore, the gas outlets 312 of the sector chamber belong to the first subgroup, i.e. they are supplied with gas. The gas is symbolically illustrated by little circles. During operation, the gas forms the hover cushion between the surface 310 and the web 500.

In light of the above, embodiments of a modular processing system can include one or more gas cushion rollers as described above. These gas cushion rollers can, according to yet further implementations, be modified by additional or alternative features as follows: the curved surface can include a web guiding region, and wherein the first subgroup of the gas outlets consists of at least one gas outlet in the web guiding region and the second subgroup of gas outlets consists of at least one gas outlet outside of the web guiding region; the curved surface can be adapted for rotating with a surface velocity equal to a guiding velocity of the web such that any part of the curved surface overlapped by the web is substantially stationary with respect to the web; the gas distribution system can include a main gas feed, individual gas outlet feeds in fluid communication with the gas outlets, the individual gas outlet feeds being adapted for selectively connecting the main gas feed to the first subgroup of the gas outlets and for selectively disconnecting the main gas feed from the second subgroup of the gas outlets; the main gas feed can be non-rotatable, the individual gas outlet feeds can be rotatable together with the curved surface, and the individual gas outlet feeds are adapted to selectively connect to or disconnect from the main gas feed depending on their relative position with respect to the main gas feed upon rotation; and/or the gas distribution system can include a multitude of sector chambers, wherein each sector chamber includes at least one gas inlet connectable to a gas outlet feed, and wherein each sector chamber is in fluid communication with a number of gas outlets that is greater than the number of gas inlets of the sector chamber, the number of gas inlets of the sector chamber preferably being one.

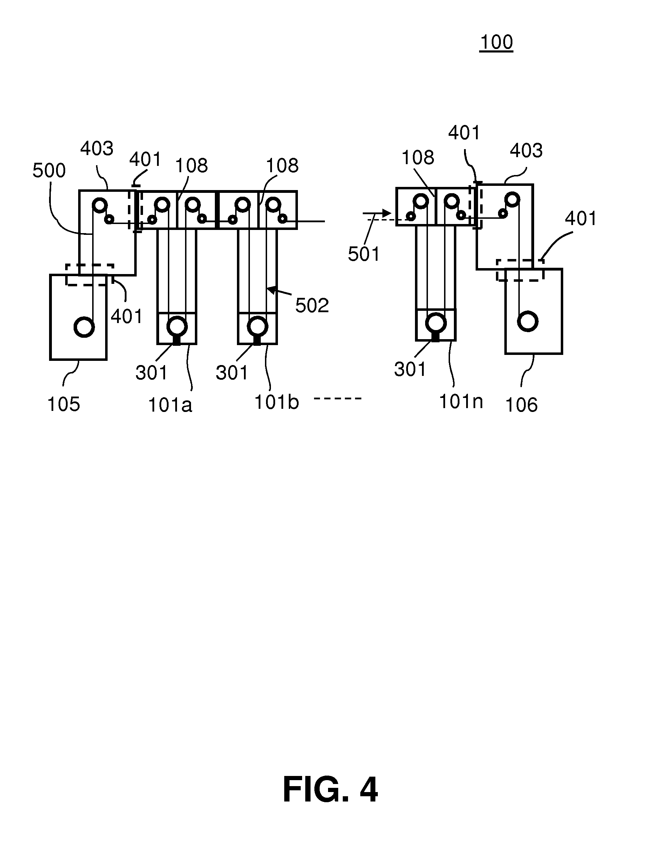

FIG. 4 is a schematic side view of a modular substrate processing system 100 in accordance with a further embodiment. It is noted here that components and parts which have been described with respect to previous figures are not detailed in the description with respect to the following figures in order to avoid a redundant description.

In addition to the modular substrate processing system 100 shown in FIG. 1, the system shown in FIG. 4 includes an unwinding module 105 where the flexible substrate 500 may be unwound from a roll such that a continuous processing of the flexible substrate 500 is achieved. Moreover, a winding module 106 may be provided at an output of the last process module 101n such that the processed flexible substrate 500 may be wound up to form a roll again.

It is noted here that a number n of process modules 101a-101n may exceed the number of individual layers to be deposited onto the flexible substrate, n being in a range from 2 to 20. The first and second processing regions 205, 206 of a process module 101a-101n, which have been described herein above with respect to FIG. 2, are separated by a gas separation device 301. The gas separation device 301 is adapted for providing a gas separation between the first processing region 205 and at least one second processing region 206 within the process module 101 and may be provided as a narrow slot through which the flexible substrate is guided. The slot itself can be additionally purged with a sweep gas, for example an inert sweeping gas, to minimize the possibility of the interchange of precursor gaseous mixtures between the two processing regions 205 and 206.

According to yet further embodiments, which can be combined with other embodiments described herein, a plurality of process modules, such as for example 2 to 20 process modules 101a-101n containing PECVD sources can be arranged such that a thickness match of the doped layer thickness to the desired intrinsic layer thickness is provided. For example, one process module is provided for an amorphous n-layer, followed by about 5 to 9, e.g. 7, process modules adapted for a deposition of an intrinsic i-layer, followed by at least one process module adapted for a deposition of an amorphous p-layer. Typically, 4 sources can be provided per module such that 2 sources are provided in each of the process regions of one process module.

According to yet further embodiments, which can be combined with other embodiments described herein, for example, 5 to 9 process modules can be provided for depositing microcrystalline silicon and 3 to 7 process modules can be provided for depositing amorphous silicon. Thereby, a double junction stack layer having an n-i-p layer structure being microcrystalline and an n-i-p layer structure being amorphous, or vice versa, can be deposited. Similar to the embodiments described above, thereby forming yet further embodiments, a majority of the modules (e.g. at least 60%) are used for the intrinsic layers of the respective layer structures. Typically, 4 sources can be provided per module such that for example 2 sources are provided in each of the process regions of one process module.

Accordingly, different further embodiments may include a plurality of plasma sources and/or process modules, the number of which is designed such that process drift associated with a formation of dust and/or particles is avoided. In light thereof, for example, a manufacture of tandem junction thin film solar cells is based on an increase in module plurality to account for film thicknesses and system productivity.

Load lock chambers 403 are used for connecting the winding/unwinding modules 106, 105 to an adjacent process module 101n, 101a. Locking devices 401 may be integrated in the winding/unwinding modules 106, 105, in the load lock chambers 403 and/or in the process modules, as indicated by broken lines in FIG. 4. These locking devices 401 located in a path between unwinding/winding modules and an adjacent process module 101a, 101n may be provided as vacuum-tight, inflatable seals. In the case where it might be necessary, for example for safety reasons, to prevent air entering the processing regions 205 and 206 through the inflatable seals, it is possible to pump the load lock chamber 403 while the load locks are closed. So even if there would be a small vacuum leak in the locking device 401 between winding/unwinding modules 106, 105 and lock chambers 403 the intruding air could not enter the processing regions 205 and 206 and cause any harm.

For example, if silane is used as a precursor gas, silane dust may be generated. As the substrate processing system 100 is designed in a roll-to-roll structure, a transfer of gaseous components from one process module to an adjacent process module or to other process modules in the processing line is an issue. Using gas separation slits between adjacent process modules 101a-101n, dopant transfer from one process module to an adjacent process module can be avoided and high quality substrate processing operations may be performed, e.g. the deposition of amorphous or microcrystalline silicon layers for high performance photovoltaic cells.

A gas separation can be provided by guiding the web through a slit and inserting a sweep gas within the slit such that the sweep gas prevents other gases from entering the slit. Thereby, according to yet further embodiments, which can be combined with other embodiments described herein, the sweep gas can be a processing gas, typically a process gas which is used on both sides of the slit, such as a carrier gas.

The sweep gas flows between the adjacent process modules and prevents the diffusion of precursor gaseous mixtures between the adjacent process modules. In addition to that, or as an alternative, process gas for a substrate processing operation may be provided.

According to different embodiments, which can be combined with other embodiments described herein, the flow of sweep gas may be combined with the transport of the flexible substrate 500 by the gas cushion rollers 201, 202 described herein above with respect to FIG. 3. Then the substrate transport can be performed with a reduced substrate surface-roller contact whilst reducing a dopant transfer from process module to process module, i.e. from processing chamber to processing chamber at the same time. For example, the use of a process gas as a sweep gas in a gas separation unit and the use of a process gas as a gas cushion gas can be combined.

In light of the above, according to one embodiment, a substrate processing system adapted for processing a flexible substrate can be provided. The system can include a gas separation unit and/or a gas cushion roller, wherein the gas separation unit and/or the gas cushion roller are adapted to operate with a process gas. Thereby, the gas inserted in the gas separation unit and the gas inserted in the gas cushion roller may be guided to the processing region without deteriorating the process. In this gas, the amount of the process gas directly inserted to the processing region might even be reduced and compensated for by the respective processing gas from the gas separation unit or the gas cushion roller.

According to yet further embodiments, which can be combined with other embodiments described herein, the modular substrate processing system 100 caninclude an unwinding module 105 where the flexible substrate 500 may be unwound from a roll such that a continuous processing of the flexible substrate 500 is achieved. In addition to that, an easy roll exchange/transfer may be provided. Moreover, a winding module 106 may be provided at an output of the last process module 101n such that the processed flexible substrate 500 may be wound up to form a roll again.

According to yet further embodiments, which can be combined with any of the other embodiments and modifications described herein, the load lock chamber 403 can be adapted for providing a gas separation and a vacuum lock.

A further load lock chamber 403 may be provided between the last process module 101n and the winding module 106. The load lock chambers 403 each include seals which can be closed for example while the flexible substrate 500 is fed through the line of process modules 101a-101n. If the seals of the load lock chambers 403 are closed, e.g. the unwinding module 105 and the winding module 106 may be exposed to atmospheric pressure while the remaining process modules 101a-101n are evacuated. In addition to that, an atmospheric contamination of the processing line may be avoided using the load lock chambers 403 at the first and the last process module 101a, 101n, respectively. The load lock chambers 403 may include locking devices provided as vacuum-tight, inflatable seals.

By an appropriate operation of the load lock chambers 403 and the locking devices 401 a new roll of flexible substrate can be inserted in the system or the roll with the processed substrate can be removed from the system without exposing the system to atmospheric pressure. Having a vacuum separation between the unwinding and winding station and other portions of the system allows for venting the unwinding and winding stations only for exchange of the substrate. This also results in significantly reduced down-times of the system.

According to yet further embodiments, which can be combined with embodiments described herein, the load lock chambers 403 and interconnection units having the locking devices 401 might be integrated in the modules or the winding/unwinding stations. For example, the modules and/or the winding/unwinding stations might be equipped with seals and/or inflatable seals for sealing adjacent modules with respect to each other. Examples of a seal are described in U.S. Pat. No. 5,254,169, which issued Oct. 19, 1993, and U.S. patent application Ser. No. 10/574,486, entitled "LOCK VALVE IN PARTICULAR FOR STRIP PROCESSING UNIT" filed May 24, 2004, both of which are incorporated herein by reference to the extent that the applications are not inconsistent with this disclosure.

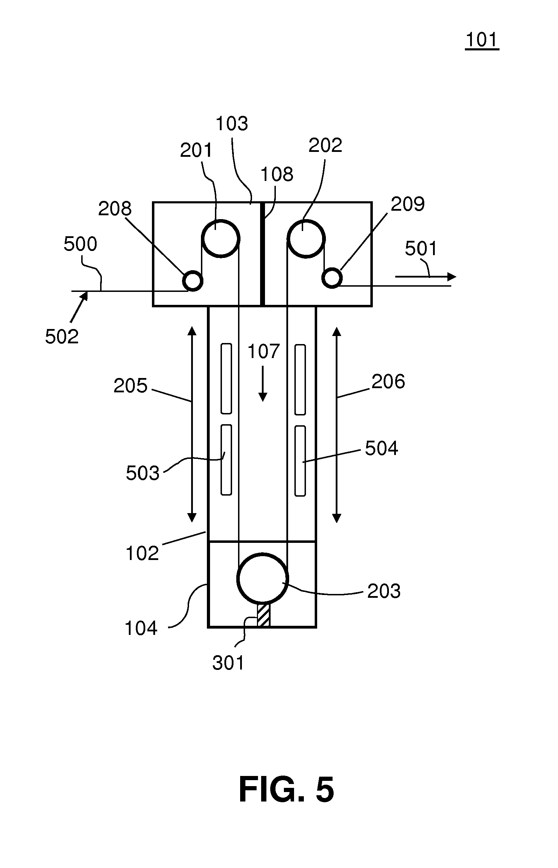

FIG. 5 is a side sectional view of a process module 101 illustrating yet further embodiments. It is noted here that components and parts which have been described with respect to the previous FIG. 2 are not detailed in the description with respect to the following figures in order to avoid a redundant description.

The process module 101 includes a substrate guiding means including a first substrate guiding device 103 and a second substrate guiding device 104. The guiding devices are adapted for guiding the flexible substrate 500 in opposite vertical directions such that an intermediate space 107 is formed between the positions of the substrate moving in the opposite vertical directions. A separation wall 108 is formed between an upstream side of the first substrate guiding means 103, where the rollers 201, 208 are arranged, and a downstream side of the first substrate guiding means 103, where the rollers 202, 209 are arranged.

According to yet further embodiments, which can be combined with other embodiments described herein, heating devices such as radiation heaters or induction heaters may be arranged in the intermediate space 107 in order to provide a desired substrate temperature for a specific processing operation. In addition to that, or alternatively, heated rollers or drums may be provided in order to heat up the moving substrate.

Two deposition sources 503, 504 such as plasma deposition sources are arranged at opposing sides of the intermediate space 107, with respect to the substrate 500, the deposition sources 503, 504 being oriented vertically and facing the front surface 502 of the substrate 500. A first deposition source 503 is arranged in a first processing region 205, and a second deposition source 504 is arranged in a second processing region 206. As the deposition source 503, 504, for example plasma deposition sources, are arranged at opposing sides of the intermediate space 107, with respect to the moving substrate 500, the sources 503, 504 may be easily exchanged in case of a repair operation.

Typically, a plasma processing device operating at low pressure conditions is provided in at least one of the processing regions 205, 206. According to yet further embodiments, which can be combined with any of the other embodiments and modifications above, the plasma processing device is a multi-region plasma source. Accordingly, different further embodiments may include a number m of plasma sources in a single process module, m being in a range from two to eight, and typically being four. Thereby, deposition sources might be provided according to any of the following embodiments: A plasma deposition source for transferring a deposition gas into a plasma phase and for depositing, from the plasma phase, a thin film onto a substrate moving in a substrate transport direction in a vacuum chamber can be provided. The plasma deposition source can include a multi-region electrode device adapted to be disposed in the vacuum chamber and including at least one RF electrode, the RF electrode having an electrode width parallel to and an electrode length perpendicular to the substrate transport direction, and being arranged opposite to the moving substrate, wherein a normalized plasma volume is provided by a plasma volume defined between the electrode surface and the opposite substrate position, divided by the electrode length, and wherein the normalized plasma volume is tuned to a depletion length of the deposition gas; and a RF power generator adapted for supplying RF power to the at least one RF electrode, wherein the RF electrode has at least one gas inlet arranged at one edge of the RF electrode and at least one gas outlet arranged at the opposing edge of the RF electrode. Within further typical modifications the plasma deposition source can be provided wherein the electrode width of the RF electrode parallel to the substrate transport direction is less than a critical depletion length of a depletion profile of the deposition gas, the critical depletion length being defined at about 10% of a maximum mole fraction of the deposition gas and/or wherein the RF electrode defines a plasma volume in a range from 1200 cm³ to 7200 cm³ between an electrode surface and an opposite substrate position, within the vacuum chamber. Further examples of a plasma source are described in U.S. patent application Ser. No. 12/476,891, entitled "Plasma deposition source and method for depositing thin films" filed June 2, 2009, which is incorporated herein by reference to the extent that the applications are not inconsistent with this disclosure.

According to yet further embodiments, which can be combined with other embodiments described herein, the first and second processing regions are separated by a gas separation device 301. The gas separation device 301 is adapted for providing a gas separation between the first processing region 205 and at least one second processing region 206 within the process module 101 and may be provided as a narrow slot through which the substrate web may pass from one processing region to an adjacent processing region. Thereby, typically a sweep gas is inserted within the slot region to prevent gases from entering the slot. Typical gases can be used according to any of the other embodiments described herein.

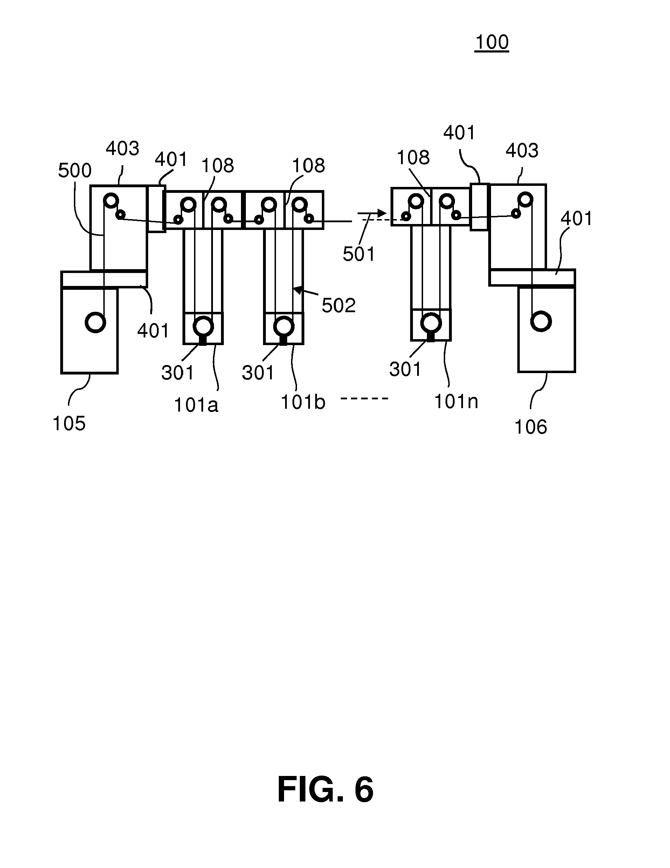

FIG. 6 is a schematic side sectional view of a modular substrate processing system 100 in accordance with yet another embodiment. It is noted that components which have been described already with reference to FIG. 4 are not described here in order to avoid a redundant description. In the substrate processing system shown in FIG. 6, the locking devices 401 are not integrated in the winding/unwinding modules 106, 105, in the load lock chambers 403 and/or in the process modules, as indicated by broken lines in FIG. 4, but are provided as separate entities. As illustrated in FIG. 6, a first locking device 401 is arranged between the unwinding module 105 and an upstream load lock chamber 403 (on the left side in FIG. 6), whereas a second locking device 401 is arranged between the winding module 106 and a downstream load lock chamber 403 (on the right side in FIG. 6). In addition to that, or alternatively, further locking devices 401 may be arranged between the upstream load lock chamber 403 and the first process module 101a, and/or between the last process module 101n and the downstream load lock chamber 403.

The gas separation devices 301 within at least one process module permit a versatile arrangement of processing steps using different gases. Thus, while the flexible substrate 500 is transported in the transport direction 501, different processing operations may be performed in different process modules, and also within one process module.

For example, processing the flexible substrate may include depositing a first layer onto the flexible substrate 500 in a first processing region 205 of the first process module 101a and depositing at least one second layer onto the flexible substrate 500 in a second processing region 206 of the first process module and in at least one second process module 101b-101n.

Furthermore, processing the flexible substrate may include depositing at least two different layers onto the flexible substrate 500 in different processing regions 205, 206, the layers having different layer thicknesses, wherein a ratio of the layer thicknesses of the two different layers approximately corresponds to a ratio of numbers of processing regions traversed by the flexible substrate. Albeit not shown in the figures, an individual process module may include more than two processing regions which may be separated by gas separation devices such that more than two different processing operations may be performed within a single process module.

According to another embodiment which may be combined with any other embodiment described herein, a first process module 101a includes a first substrate insertion unit and a first substrate ejection unit, at least one second process module 101b includes a second substrate insertion unit and a second substrate ejection unit, and at least one interconnection unit is adapted for interconnecting the first substrate ejection unit to the second substrate insertion unit.

According to yet further embodiments, which can be combined with other embodiments described herein, the substrate processing system 100 may include at least one monitoring unit adapted for monitoring a substrate processing operation. In order to monitor a processing operation, voltages, currents, film thicknesses, film thickness variations, film compositions, and other data relevant for the processing operation may be detected, analyzed and used for controlling specific processes.

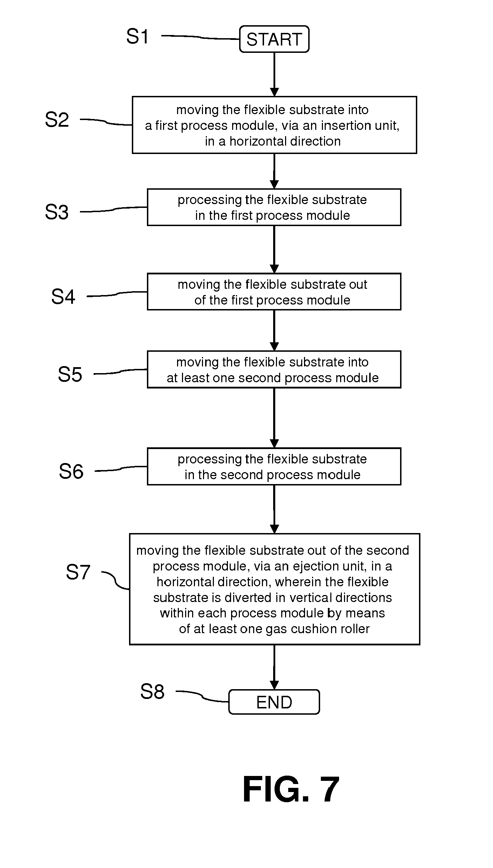

FIG. 7 is a flowchart illustrating a method for processing a flexible substrate 500. At a step S1 the procedure is started. Then, at a following step S2, the flexible substrate is moved into a first process module, via an insertion unit, in a horizontal direction. The step S2 may include unwinding a flexible substrate from a roll which may be provided in an unwinding module.

Then the procedure advances to a following step S3 where the flexible substrate 500 is processed in the first process module 101a. In detail, the flexible substrate 500 is guided through the first process module 101a as follows. The horizontally inserted flexible substrate 500 is diverted in vertical directions 501, 501' by means of the first and second substrate guiding devices 103, 104.

After inserting the flexible substrate 500 into the first substrate guiding device 103 an input roller 208 contacting the substrate at its back side opposing the front surface 502 guides the substrate 500 to an upstream gas cushion roller 201 which provides a gas cushion between the front surface and a roller surface.

Then the flexible substrate 500 is diverted downwards in a vertical direction. The flexible substrate 500 moves downward through a first processing region 205 of the first process module 101a. Then the flexible substrate 500 is inserted into the second substrate guiding device 104 where the flexible substrate 500 is diverted from a vertical downward movement to a vertical upward movement by means of an intermediate roller 203.

Then the substrate 500 passes the second processing region 206 of the first process module 101a and enters the first substrate guiding device 103. After being diverted by the downstream gas cushion roller 202 and an output roller 209 the substrate 500 is moved out from the first process module 101a at a step S4. It is noted here that process gas for processing the flexible substrate 500 may be provided, at least partially, by at least one gas cushion roller 201, 202 of the first process module 101a.

Then the procedure advances to a step S5 where the flexible substrate is moved into at least one second process module 101b-101n, and then to a following step S6 where the flexible substrate 500 is processed in the second process module.

In a similar manner as in the first process module 101a, the flexible substrate 500 is guided through the second process module as follows. The horizontally inserted flexible substrate 500 is diverted in vertical directions by means of the first and second substrate guiding devices 103, 104.

After inserting the flexible substrate 500 into the first substrate guiding device 103 an input roller 208 contacting the substrate 500 at its back side opposing the front surface 502 guides the substrate 500 to an upstream gas cushion roller 201 of the second process module. Then the flexible substrate 500 is diverted downwards in a vertical direction.

The flexible substrate 500 moves downward through a first processing region 205 of the second process module. Then the flexible substrate 500 is inserted into the second substrate guiding device 104 where the flexible substrate 500 is diverted, in its movement, from a vertical downward movement to a vertical upward movement by means of an intermediate roller 203. Then the substrate 500 passes through the second processing region 206 of the second process module and enters into the first substrate guiding device 104 of the second process module.

After being diverted by the downstream gas cushion roller 202 and an output roller 209 the substrate 500 is ejected from the second process module at a step S7. At the step S7 the flexible substrate 500 is moved out of the second process module, via an ejection unit, in the horizontal direction 501. It is noted here that process gas for processing the flexible substrate may be provided, at least partially, by at least one gas cushion roller of the second process module.

According to yet further embodiments, which can be combined with other embodiments described herein, the flexible substrate 500 may be wound up on a roll by means of a winding module 106 such that a roll-to-roll process may be established.

Accordingly, different further embodiments may include a gas separation between a first processing region and at least one second processing region of an individual process module 101a-101n. The gas separation is provided within at least one process module using a gas separation device 301 arranged within the respective process module 101a-101n.

According to different embodiments, which can be combined with other embodiments described herein, a gas separation and a vacuum lock are provided at at least one of the insertion unit of the first process module and the ejection unit of the last process module.

According to yet further embodiments, which can be combined with other embodiments described herein, processing the flexible substrate 500 may include depositing a first layer onto the flexible substrate 500 in a first processing region 205 of the first process module 101a and depositing at least one second layer onto the flexible substrate 500 in a second processing region 206 of the first process module 101a and in at least one second process module 101b-101n.

Furthermore, processing the flexible substrate 500 may include depositing at least two different layers onto the flexible substrate 500 in different processing regions 205, 206, the layers having different layer thicknesses, wherein a ratio of the layer thicknesses of the two different layers approximately corresponds to a ratio of numbers of processing regions 205, 206 traversed by the flexible substrate 500.

According to different embodiments, which can be combined with other embodiments described herein, an interconnection unit is provided between adjacent process modules 101a-101n, the interconnection unit being used as a gas insertion module adapted for flowing sweep gas between two adjacent process modules 101a-101n.

In light of the above, a plurality of embodiments have been described. For example, according to one embodiment, a modular substrate processing system for processing a flexible substrate is provided. The system includes at least two process modules arranged adjacent to each other in a horizontal direction, wherein the process modules include gas cushion rollers adapted for contactless guiding of the flexible substrate and for diverting the flexible substrate in vertical directions. According to yet further embodiments, which can be combined with other embodiments described herein, at least one process module includes a gas separation device adapted for providing a gas separation between a first processing region and at least one second processing region within the process module. The gas cushion rollers may provide process gas for processing the flexible substrate. Furthermore, the gas cushion rollers are arranged to face a front surface of the flexible substrate. According to an optional modification thereof, the system further includes at least one unwinding module adapted for unwinding the flexible substrate. According to another optional modification thereof, the system includes at least one winding module adapted for winding up the flexible substrate. According to yet further embodiments, which can be combined with other embodiments described herein, a locking device is provided between at least one of the unwinding module and the winding module, and an adjacent process module, the locking device being adapted for providing a gas separation and a vacuum lock. According to an optional modification thereof the system further includes at least one interconnection unit adapted for interconnecting adjacent process modules and for guiding the flexible substrate from one process module to an adjacent process module, wherein the interconnection unit may be provided as a vacuum flange. According to an optional modification thereof, the interconnection unit is provided as a gas insertion module adapted for flowing sweep gas between two adjacent process modules. According to yet further embodiments, which can be combined with any of the other embodiments and modifications above, a number n of process modules exceeds the number of individual layers to be deposited onto the flexible substrate, n being in a range from 2 to 20.

According to yet further additional or alternative modifications the process modules may include a substrate guiding means adapted for guiding the flexible substrate in opposite vertical directions such that an intermediate space is formed between the positions of the substrate moving in the opposite vertical directions, and at least one plasma source arranged at opposing sides of the intermediate space, with respect to the substrate, the plasma source being oriented vertically and facing the front surface of the substrate. According to an optional modification thereof, the substrate guiding means includes at least one gas cushion roller. Moreover, a plasma processing device operating at low pressure conditions may be provided in at least one processing region. According to an optional modification thereof, the plasma processing device is a multi-region plasma source. According to yet further embodiments, which can be combined with any of the other embodiments and modifications above, a first process module includes a first substrate insertion unit and a first substrate ejection unit, at least one second process module includes a second substrate insertion unit and a second substrate ejection unit, and the at least one interconnection unit is adapted for interconnecting the first substrate ejection unit to the second substrate insertion unit,. In addition to that the system may include at least one monitoring unit adapted for monitoring a substrate processing operation. According to yet further embodiments, which can be combined with any of the other embodiments and modifications above, a modular substrate processing system adapted for processing a flexible substrate is provided, wherein the system includes at least two process modules arranged adjacent to each other in a horizontal direction, wherein at least one process module includes a first processing region, at least one second processing region, and a gas separation device adapted for providing a gas separation between the first processing region and the second processing region within the process module. According to another embodiment, a method of processing a flexible substrate is provided. The method includes moving the flexible substrate into a first process module, via an insertion unit, in a horizontal direction; processing the flexible substrate in the first process module; moving the flexible substrate out of the first process module; moving the flexible substrate into at least one second process module; processing the flexible substrate in the second process module; and moving the flexible substrate out of the second process module, via an ejection unit, in a horizontal direction, wherein the flexible substrate is diverted in vertical directions within each process module by means of at least one gas cushion roller. According to an optional modification thereof, a gas separation between a first processing region and at least one second processing region within at least one process module is provided by a gas separation device arranged within the respective process module. Furthermore, a gas separation and a vacuum lock may be provided at at least one of the insertion unit and the ejection unit. According to yet further additional or alternative modifications process gas for processing the flexible substrate may be provided, at least partially, by at least one gas cushion roller. According to another embodiment, processing the flexible substrate includes depositing a first layer onto the flexible substrate in a first processing region of the first process module and depositing at least one second layer onto the flexible substrate in a second processing region of the first process module and in the at least one second process module. According to yet further embodiments, which can be combined with any of the other embodiments and modifications above, processing the flexible substrate may include depositing at least two different layers onto the flexible substrate in different processing regions, the layers having different layer thicknesses, wherein a ratio of the layer thicknesses of the two different layers approximately corresponds to a ratio of numbers of processing regions traversed by the flexible substrate.

While the foregoing is directed to embodiments of the invention, other and further embodiments of the invention may be devised without departing from the basic scope thereof, and the scope thereof is determined by the claims that follow.

## Claims

1. A modular substrate processing system adapted for processing a flexible substrate, the system comprising:
at least two process modules arranged adjacent to each other in a horizontal direction,
wherein the process modules comprise gas cushion rollers adapted for contactless guiding the flexible substrate and for diverting the flexible substrate in vertical directions.

2. The system in accordance with claim 1, wherein the gas cushion rollers are adapted to provide process gas for processing the flexible substrate.

3. The system in accordance with any of the preceding claims, further comprising at least one unwinding module adapted for unwinding the flexible substrate and/or at least one winding module adapted for winding up the flexible substrate.

4. The system in accordance with claim 3, wherein a locking device is provided between at least one of the unwinding module and the winding module, and an adjacent process module, the locking device being adapted for providing a gas separation and a vacuum lock.

5. The system in accordance with any of the preceding claims, further comprising at least one interconnection unit adapted for interconnecting adjacent process modules and for guiding the flexible substrate from one process module to an adjacent process module.

6. The system in accordance with claim 5, wherein the interconnection unit is provided as a gas insertion module adapted for flowing sweep gas between two adjacent process modules.

7. The system in accordance with any of the preceding claims, wherein a number n of process modules exceeds the number of individual layers to be deposited onto the flexible substrate, n being in a range from 2 to 20.

8. The system in accordance with any of the preceding claims, wherein the process modules comprise a substrate guiding means adapted for guiding the flexible substrate in opposite vertical directions such that an intermediate space is formed between the positions of the substrate moving in the opposite vertical directions, and at least one plasma source arranged at opposing sides of the intermediate space, with respect to the substrate, the plasma source being oriented vertically and facing the front surface of the substrate.

9. The system in accordance with any of the preceding claims, wherein a plasma processing device operating at low pressure conditions is provided in at least one processing region.

10. The system in accordance with claim 9, wherein the plasma processing device is a multi-region plasma source.

11. The system in accordance with any of the preceding claims, wherein at least one process module comprises a first processing region, at least one second processing region, and a gas separation device adapted for providing a gas separation between the first processing region and the second processing region within the process module.

12. A method for processing a flexible substrate, the method comprising:
moving the flexible substrate into a first process module, via an insertion unit, in a horizontal direction;
processing the flexible substrate in the first process module;
moving the flexible substrate out of the first process module;
moving the flexible substrate into at least one second process module;
processing the flexible substrate in the second process module; and
moving the flexible substrate out of the second process module, via an ejection unit, in a horizontal direction,
wherein the flexible substrate is diverted in vertical directions within each process module by means of at least one gas cushion roller.

13. The method in accordance with claim 12, wherein processing the flexible substrate comprises depositing a first layer onto the flexible substrate in a first processing region of the first process module and depositing at least one second layer onto the flexible substrate in a second processing region of the first process module and in the at least one second process module.

14. The method in accordance with claim 12 or 13, wherein processing the flexible substrate comprises depositing at least two different layers onto the flexible substrate in different processing regions, the layers having different layer thicknesses, wherein a ratio of the layer thicknesses of the two different layers approximately corresponds to a ratio of numbers of processing regions traversed by the flexible substrate.

15. The method in accordance with any one of the claims 12 to 14, wherein a gas separation between a first processing region and at least one second processing region within at least one process module is provided by a gas separation device arranged within the respective process module.

## Amended claims

### Amended claims in accordance with Rule 137(2) EPC.

**1.** A modular substrate processing system (100) adapted for depositing at least one layer on a flexible substrate (500), the system comprising:
at least two process modules (101a, 101b, ..., 101n) arranged adjacent to each other in a horizontal direction,
wherein the process modules comprise gas cushion rollers (200, 201, 202) adapted for contactless guiding the flexible substrate (500) and for diverting the flexible substrate in vertical directions, and
wherein at least one of the process modules (101a, 101b, ..., 101n) is adapted to be evacuated.

**2.** The system in accordance with claim 1, wherein the gas cushion rollers (200, 201, 202) are adapted to provide process gas (303) for processing the flexible substrate (500).

**3.** The system in accordance with any of the preceding claims, further comprising at least one unwinding module (105) adapted for unwinding the flexible substrate (500) and/or at least one winding module (106) adapted for winding up the flexible substrate.

**4.** The system in accordance with claim 3, wherein a locking device (401) is provided between at least one of the unwinding module (105) and the winding module (106), and an adjacent process module (101a, 101b, ... , 101n), the locking device being adapted for providing a gas separation and a vacuum lock.

**5.** The system in accordance with any of the preceding claims, further comprising at least one interconnection unit adapted for interconnecting adjacent process modules (101a, 101b, ... , 101n) and for guiding the flexible substrate (500) from one process module to an adjacent process module.

**6.** The system in accordance with claim 5, wherein the interconnection unit is provided as a gas insertion module adapted for flowing sweep gas between two adjacent process modules (101a, 101b, ... , 101n).

**7.** The system in accordance with any of the preceding claims, wherein a number n of process modules (101a, 101b, ..., 101n) exceeds the number of individual layers to be deposited onto the flexible substrate (500), n being in a range from 2 to 20.

**8.** The system in accordance with any of the preceding claims, wherein the process modules (101a, 101b, ... , 101n) comprise a substrate guiding means (103, 104) adapted for guiding the flexible substrate (500) in opposite vertical directions such that an intermediate space (107) is formed between the positions of the substrate moving in the opposite vertical directions, and at least one plasma source arranged at opposing sides of the intermediate space (107), with respect to the substrate, the plasma source being oriented vertically and facing the front surface (502) of the substrate.

**9.** The system in accordance with any of the preceding claims, wherein a plasma processing device operating at low pressure conditions is provided in at least one processing region (205, 206).

**10.** The system in accordance with claim 9, wherein the plasma processing device is a multi-region plasma source.

**11.** The system in accordance with any of the preceding claims, wherein at least one process module comprises a first processing region (205), at least one second processing region (206), and a gas separation device (301) adapted for providing a gas separation between the first processing region and the second processing region within the process module (101a, 101b, ... , 101n).

**12.** A method for depositing at least one layer on a flexible substrate (500), the method comprising:
moving the flexible substrate into a first process module, via an insertion unit, in a horizontal direction (S2);
processing the flexible substrate in the first process module (S3);
moving the flexible substrate out of the first process module (S4);
moving the flexible substrate into at least one second process module (S5);
processing the flexible substrate in the second process module (S6); and
moving the flexible substrate out of the second process module, via an ejection unit, in a horizontal direction,
wherein the flexible substrate is diverted in vertical directions within each process module by means of at least one gas cushion roller (S7), and wherein at least one of the process modules is evacuated and at least one of the processing operations comprises depositing a layer on a substrate.

**13.** The method in accordance with claim 12, wherein processing the flexible substrate (500) comprises depositing a first layer onto the flexible substrate in a first processing region (205) of the first process module (101a, 101b, ... , 101n) and depositing at least one second layer onto the flexible substrate in a second processing region (206) of the first process module and in the at least one second process module.

**14.** The method in accordance with claim 12 or 13, wherein processing the flexible substrate (500) comprises depositing at least two different layers onto the flexible substrate in different processing regions (205, 206), the layers having different layer thicknesses, wherein a ratio of the layer thicknesses of the two different layers approximately corresponds to a ratio of numbers of processing regions traversed by the flexible substrate.

**15.** The method in accordance with any one of the claims 12 to 14, wherein a gas separation between a first processing region (205) and at least one second processing region (206) within at least one process module (101a, 101b, ... , 101n) is provided by a gas separation device (301) arranged within the respective process module.
